# EUROPÄISCHE PATENTSCHRIFT

(11) **EP 1 112 594 B1**
(45) Veröffentlichungstag und Bekanntmachung des Hinweises auf die Patenterteilung: **01.12.2010**
(21) Anmeldenummer: 99968740.3
(22) Anmeldetag: 08.09.1999
(51) Int. Cl.: H01L 29/732, H01L 29/737, H01L 29/10, H01L 21/331

(54) **VERTIKALER BIPOLARTRANSISTOR UND VERFAHREN ZU SEINER HERSTELLUNG**
VERTICAL BIPOLAR TRANSISTOR AND METHOD FOR THE PRODUCTION THEREOF
TRANSISTOR BIPOLAIRE VERTICAL ET PROCEDE DE FABRICATION DUDIT TRANSISTOR

(30) Priorität: 08.09.1998 DE 19842106
(43) Veröffentlichungstag der Anmeldung: 04.07.2001
(73) Patentinhaber: IHP GmbH-Innovations for High Performance Microelectronics / Leibniz-Institut für innovative Mikroelektronik, 15236 Frankfurt / Oder (DE)
(72) Erfinder: EHWALD, Karl-Ernst, D-15234 Frankfurt an der Oder (DE); KNOLL, Dieter, D-15230 Frankfurt an der Oder (DE); HEINEMANN, Bernd, D-15234 Frankfurt an der Oder (DE)
(74) Vertreter: Eisenführ, Speiser & Partner
(86) Internationale Anmeldenummer: PCT/DE1999/002884
(87) Internationale Veröffentlichungsnummer: WO 2000/014806

(56) Entgegenhaltungen:
- EP-A- 0 550 962
- DE-A- 4 301 333
- US-A- 5 696 007

## Beschreibung

Die Erfindung bezieht sich auf einen vertikalen Bipolartransistor und ein Verfahren zu seiner Herstellung.

Der Kollektorwiderstand, der entscheidend die Hochfrequenzeigenschaften von Bipolartransistoren mitbestimmt, hat bei konventionellen Transistorkonstruktionen eine gewöhnlich nicht zu vernachlässigende parasitäre Lateralkomponente.

Diese kommt dadurch zustande, daß übliche Konstruktionen für vertikale Bipolartransistoren einen Kollektoranschluß benutzen, der vom Basisgebiet des aktiven (inneren) Transistors lateral durch Feldoxid getrennt ist, und ein Basisanschlußgebiet, das üblicherweise allseitig den Emitter umschließt, um den für die Hochfrequenzeigenschaften des Transistors ebenfalls wichtigen Basiswiderstand gering zu halten. Dabei wird der minimale Abstand zwischen Kollektoranschluß und innerem Transistor bei einer gegebenen, zur Realisierung eines minimalen Basisanschlußwiderstandes nicht unterschreitbaren lateralen Ausdehnung des Basisanschlußgebietes durch die jeweiligen Entwurfsregeln für den Maskenschritt, der die Feldoxidgebiete definiert, festgelegt und entspricht mindestens den durch die Strukturerzeugung bestimmten Minimalabmessungen.

Die Größe der parasitären Lateralkomponente des Kollektorwiderstandes wird, außer durch die laterale Abmessung des Feldoxidgebietes, maßgeblich durch den Schichtwiderstand des Subkollektors beeinflußt. Der Subkollektor besteht aus einer hochdotierten Halbleiterzone, die in vertikaler Richtung vom Basisgebiet des aktiven Transistors durch eine deutlich schwächer dotierte, meist durch Epitaxie hergestellte Kollektorschicht getrennt ist. Eine Reduzierung des Schichtwiderstandes dieser Anordnung unter das bereits erreichte und praktisch genutzte Niveau ist technologisch kaum möglich. Es ist aber im Gegenteil wünschenswert, sehr gute Hochfrequenzeigenschaften auch mit relativ einfach herstellbaren, "retrograd" implantierten Kollektorprofilen zu erreichen, zu deren Realisierung weder eine Epitaxieschicht noch ein getrennt hergestellter Subkollektor benutzt wird und die daher mit einem verhältnismäßig hohen Kollektorwiderstand gekoppelt sind. Es sind zwar Lösungen z. B. aus EP 227 970 B1 bekannt, mit derartigen implantierten retrograden Kollektorprofilen dennoch brauchbare Kollektorwiderstände und gute Hochfrequenzeigenschaften zu erreichen, jedoch haben diese Lösungen den Nachteil eines aufwendigen Herstellungsprozesses mit mindestens zwei sich überlappenden Polysiliziumebenen für den Basisanschluß und den Emitter. Daher wird die angestrebte kostensenkende Vereinfachung des Herstellungsprozesses mit den erwähnten bekannten Lösungen nicht oder nur teilweise erreicht.

Weitere bekannte Bipolartransistoren mit tiefer liegendem Kollektoranschluß sind in den Dokumenten DE 43 01 333 A1, US 5,696,007 und EP 5 550 962 A2 beschrieben.

Aufgabe der Erfindung ist es, einen vertikalen Bipolartransistor und eine Verfahren zu seiner Herstellung vorzuschlagen, wobei ausgezeichnete Hochfrequenzeigenschaften des Transistors mit einer möglichst einfachen Herstellungstechnologie erreicht werden. Weiterhin wünschenswert ist eine Verfahrensführung, die mit einem implantierten epitaxiefreien Kollektor und nur einer großflächig abgeschiedenen Polysiliziumebene auskommt und leicht in einen konventionellen "Mainstream-CMOS-Prozeß" ohne epitaxial hergestellte Wannengebiete integrierbar ist.

Die genannte Aufgabe wird durch einen vertikalen Bipolartransistor nach Anspruch 1 und ein Verfahren zur Herstellung eines solchen vertikalen Bipolartransistors nach Anspruch 5 gelöst.

Eine Vereinfachung der Herstellungstechnologie bei gleichzeitiger Verbesserung der Hochfrequenzparameter vertikaler Bipolartransistoren über eine Reduzierung der parasitären lateralen und vertikalen Kollektorwiderstandskomponenten wird erfindungsgemäß durch eine selbstjustierende Transistorkonstruktion in Verbindung mit einem speziellen Herstellungsverfahren erreicht, bei welchem ein die aktive Basis ringförmig umgebendes hochdotiertes einkristallines Basisanschlußgebiet im Bereich des Kollektoranschlusses durch reaktives Ionenätzen zusammen mit der darunterliegenden schwächerdotierten Zone des Kollektors oder mit einem Teil desselben entfernt wird. Dadurch wird eine Selbstpositionierung des tieferliegenden Kollektoranschlusses zum Basisgebiet ermöglicht, die es erlaubt, den Abstand zwischen dem silizierten Kollektoranschluß und dem gleichfalls silizierten einkristallinen Basisanschlußgebiet durch einen konventionell an der Ätzstufe hergestellten Spacer aus isolierendem Material auf das funktionell bedingte Minimum zu reduzieren. Durch die Entfernung der schwächerdotierten Kollektorzone entfällt die Notwendigkeit einer sogenannten Kollektorschachtimplantation, und die vertikale Komponente des Kollektoranschlußwiderstandes wird ebenfalls verringert. Vor der erfindungsgemäßen, vorzugsweise gemeinsamen, selbstpositionierenden Silizierung (Salizierung) von Basisanschluß- und KollektoranschluLigebiet ist lediglich eine flache Hochdosisimplantation erforderlich, wie die Erzeugung flacher S/D-Gebiete in modernen MOS-Technologien üblich. Ausgenommen von der Salizierung sind lediglich schmale, durch die Spacer aus isolierendem Material bzw. durch den das Basisanschlußgebiet überlappenden Emitter abgedeckte Randzonen des Basis- bzw. Kollektoranschlußgebietes. Der auf diese Weise selbstpositioniert zum Basisanschlußgebiet hergestellte Kollektoranschluß umgibt den inneren Transistor im allgemeinen an drei Seiten, so daß die Lateralkomponente des Kollektorwiderstandes im Sinne der Aufgabenstellung weiter minimiert wird. Bei Integration des erfindungsgemäß hergestellten Bipolariransistors in einem CMOS-Prozeß kann die Silizierung des Basis- und Kollektoranschlusses zweckmäßigerweise gemeinsam mit der Silizierung der S/D- und Gategebiete erfolgen.

In einer besonders vorteilhaften Ausführungsform der Erfindung weist das Basisanschlußgebiet einen zweiten äußeren Teilbereich auf, welcher aus einem Metallsilizid auf einer hochdotierten polykristallinen Schicht des gleichen Materials und vom gleichen Dotierungstyp wie der innere einkristalline Teilbereich besteht. Dieser äußere Teilbereich ist durch eine dicke Isolationsschicht vom Kollektor bzw. vom einkristallinen Halbleitersubstrat getrennt und weist deshalb zum Kollektor bzw. zum einkristallinen Halbleitersubstrat im Vergleich zum ersten Teilbereich eine sehr geringe Kapazität auf.

In einer weiteren besonders vorteilhaften Ausfiihrungsform der Erfindung ist der Kollektor und Subkollektor der npn-Bipolartransistoren Bestandteil eines durch P-Ionenimplantation im Halbleitersubstrat erzeugten retrograden Dotierungsprofils, welches auch als Wanne der auf der gleichen Scheibe integrierten MOS-Transistoren benutzt werden kann. Obwohl im Vergleich zu herkömmlichen Transistorkonstruktionen mit epitaxialem Kollektor und einer hochdotierten vergrabenen Subkollektorschicht der Subkollektor eines derart erzeugten Bipolamansistors einen um ein Mehrfaches höheren Schichtwiderstand aufweist, ist der Kollektorwiderstand vergleichbar mit demjenigen von Standardkonstruktionen mit Epitaxie und vergrabenem Subkollektor.

Die innere Basis und der einkristalline Teilbereich des Basisanschlußgebietes bestehen vorzugsweise aus epitaxial abgeschiedenem Silizium oder Silizium-Germanium. Konstruktionen mit implantiertem Basisgebiet sind im Rahmen dieser Erfindung jedoch ebenfalls möglich, ebenso wie die hier beschriebene Erfindung auch bei Verwendung konventioneller Bipolarwannen mit niederohmigem Subkollektor und epitaxialem Kollektor dazu benutzt werden kann, den Kollektorwiderstand gegenüber den bekannten Standardkonstruktionen noch weiter abzusenken und dadurch z. B. die Grenzfrequenz f, und die maximale Schwingfrequenz fₘₐₓ über die mit Standardkonstruktionen bisher erreichten Werte hinaus zu erhöhen.

Verfahrenstechnisch kann diese Konstruktion dadurch besonders günstig realisiert werden, daß in einem zusammenhängenden aktiven Gebiet, welches den späteren Kollektoranschluß mit enthält, zunächst Subkollektor, Kollektor, Basis und eine diese bedeckende Isolatorschicht übereinander erzeugt und Emitterfenster in die Isolatorschicht eingebracht werden.

Anschließend wird ein die Emitterfenster überlappender, vorzugsweise aus hochdotiertem Polysilizium bestehender Emitter abgeschieden. Danach wird, vorzugsweise selbst justiert zum Polysilizium des Emitters, das den Emitter umgebende Basisanschlußgebiet im Vergleich zur inneren Basis sehr hoch dotiert und anschließend im Bereich des späteren Kollektoranschlusses durch einen geeigneten anisotropen Ätzschritt vollständig entfernt, zusammen mit mindestens einem Teil des schwachdotierten Kollektors. Während dieses Ätzschrittes werden die innere Basis einschließlich des sie bedeckenden Emitters und das spätere Basisanschlußgebiet durch eine Lack- oder Hartmaske geschützt. Durch einen selbstjustierend an der beim Ätzen entstandenen nahezu senkrechten Stufe erzeugten Spacer aus isolierendem Material wird bei einem nachfolgenden Salizidprozeß mit Silizidbildung auf dem tieferliegenden Kollektoranschluß und vorzugsweise gleichzeitig auch auf dem Basisanschlußgebiet die Silizidbildung an der Stufenwand verhindert.

Bei Verwendung einer epitaxialen Basis wird mindestens ein Teil der polykristallinen Schicht, welche den äußeren Teilbereich bildet, während der epitaxialen Abscheidung des ersten Teilbereichs des Basisanschlußgebietes simultan abgeschieden. Die selbstpositionierende Implantation, der hochdotierten Halbleiterzone unter dem Metallsilizid des Kollektoranschlusses wird in einer weiteren günstigen Verfahrensvariante durch eine für besagte Implantation undurchlässige, beim reaktiven Ionenätzen der Basis und der schwachdotierten Kollektorzone verwendete Hilfsmaske und durch einen nach dem Ätzen des schwachdotierten Kollektorgebietes an den Ätzkanten erzeugten Spacer ermöglicht.

Weitere günstige Verfahrensvarianten werden in den entsprechenden Unteransprüchen und im Ausführungsbeispiel beschrieben.

Die Merkmale der Erfindung gehen außer aus den Ansprüchen auch aus der Beschreibung und der Zeichnung hervor, wobei die einzelnen Merkmale jeweils für sich allein oder zu mehreren in Form von Unterkombinationen schutzfähige Ausführungen darstellen, für die hier Schutz beansprucht wird. Ein Ausführungsbeispiel der Erfindung ist in den Zeichnungen dargestellt und wird im folgenden näher erläutert.

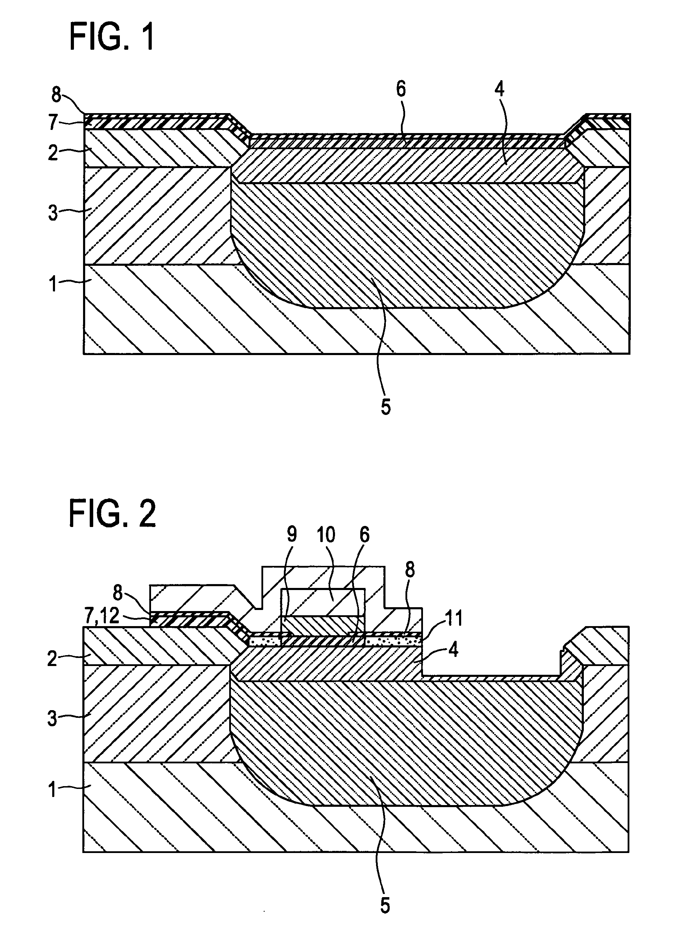

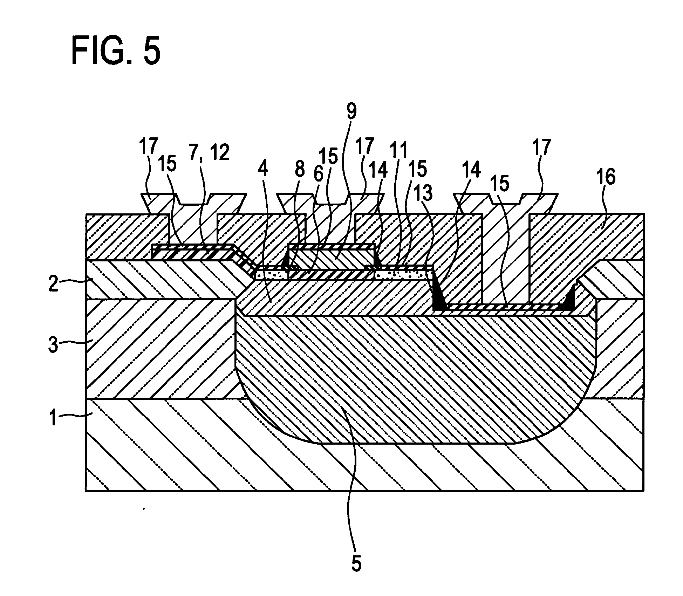

Fig. 5 zeigt den schematischen Aufbau eines vertikalen npn Silizium/Silizium-Germanium-Heterojunction Bipolar-Transistors mit implantiertem Kollektor, epitaxialer Basis und zum Basisanschlußgebiet selbstpositioniertem Kollektoranschluß. Die Fig. 1 bis 4 verdeutlichen verschiedene Abschnitte des Herstellungsprozesses.

Das Beispiel geht von einer konventionell hergestellten Grundstruktur in einem p-leitenden Silizium-Substrat 1 aus. Das Substrat enthält durch LOCOS-Oxidation erzeugte Feldoxid-Gebiete 2 mit darunter angeordneten Silizium-Gebieten 3, die vom gleichen Leitungstyp wie das Substrat sind, aber ein höheres Dotierniveau besitzen.

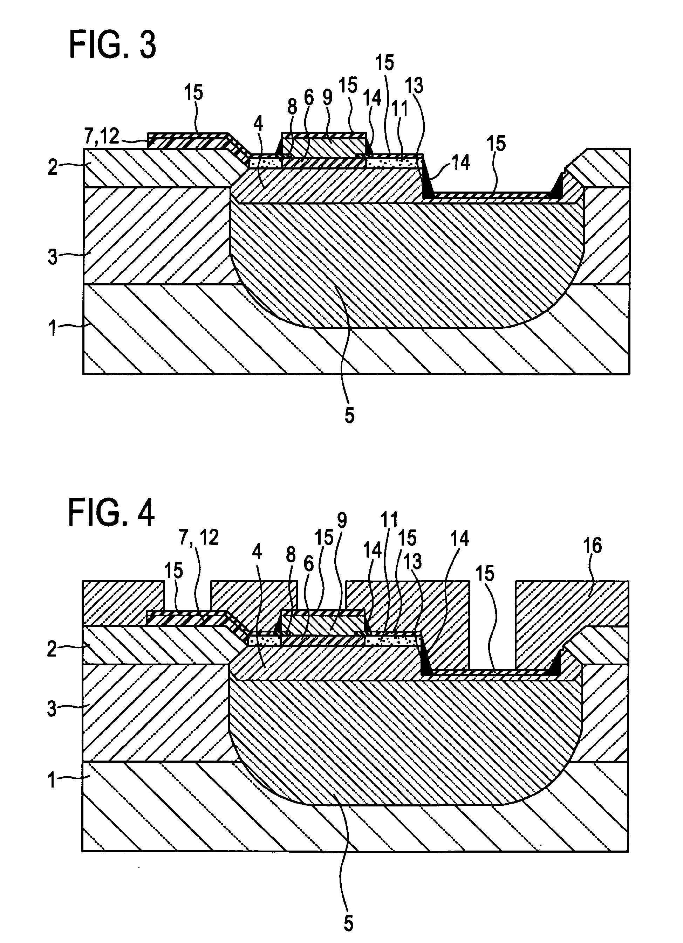

In diese Grundstruktur wird mittels Implantation von vorzugsweise Phosphor-Ionen ein Dotierungsprofil eingebracht, das von der Oberfläche beginnend in der Konzentration der eingebrachten Dotieratome zunimmt und erst in der Tiefe ein Maximum erreicht (retrogrades Dotierungsprofil) und welches Subkollektorgebiete 5 und die Kollektorgebiete 4 des Transistors bildet. Während der Implantation ist bei geeigneter Wahl der Implantationsenergie und Gestaltung der Feldoxid-Gebiete 2 und der Silizium-Gebiete 3 keine gesonderte Maskierung erforderlich, wodurch gewährleistet ist, daß die Kollektorgebiete 4 und die Subkollektorgebiete 5 im gesamten Raum zwischen den Silizium-Gebieten 3 entstehen, die die äußere Transistorbegrenzung bilden. Nach Ausheilung der Implantationsschäden und einer geeigneten Reinigung der freigelegten aktiven Silizium-Gebiete erfolgt die epitaxiale Abscheidung des Basis-Schichtstapels 6, der eine Silizium-Germanium-Schicht mit hoher Bor-Dotierung enthält, welche während des Epitaxieprozesses eingebracht wird. Der Epitaxieprozeß wird so gesteuert, daß auf den Feldoxid-Gebieten 2 simultan eine polykristalline Schicht 7 aufwächst, die eine etwa vergleichbare Dicke wie der epitaxiale Silizium-Germanium-Schichtstapel 6 aufweist und sich lateral an diesen ohne Unterbrechung anschließt (Fig. 1). Nach Abscheidung einer SiO₂-Schicht 8 wird diese mittels üblicher Fotolack- und Ätztechnik in den Gebieten entfernt, die den inneren Transistor bilden. Nach Entfernung der Lackmaske und geeigneter Reinigung erfolgt nacheinander die Abscheidung einer in Situ Arsen-dotierten Polysiliziumschicht 9 und einer Si₃N₄-Schicht 10. Die Polysiliziumschicht 9 und die Si₃N₄-Schicht 10 werden anschließend unter Verwendung einer zweiten Lackmaske, welche die in die SiO₂-Schicht 8 geätzten Fenster vollständig mit einer vorgegebenen geringen Überlappung bedeckt, mittels anisotroper Ionenätzung bis auf die Bereiche des späteren Polysiliziumemitters mit Ätzstopp auf der SiO₂-Schicht 8 entfernt. Nach Entfernung der Lackmaske werden selbstjustierend zum mit Si₃N₄-bedeckten Emitter die freigelegten Bereiche des Basisschichtstapels mit einer hohen Dosis von BF₂- Ionen implantiert. Die so entstandenen hochdotierten, im Bereich der Kollektorgebiete **5** einkristallinen und im Bereich der Feldoxid-Gebiete 2 polykristallinen Silizium-Germanium/Silizium-Schichtstapel werden mit einer weiteren Si₃N₄-Schicht bedeckt und anschließend mittels einer dritten Lackmaske so strukturiert, daß nur die inneren und äußeren Teilbereiche 11 und 12 des Basisanschlußgebietes erhalten bleiben. Dabei wird unter Ausnutzung des guten Ätzstopps des reaktiven Ionenätzens auf den Feldoxid-Gebieten 2 in den Kollektorgebieten **4** nach Entfernung des epitaxialen Silizium-Germanium-Schichtstapels 6 die Ätzung so lange fortgesetzt, bis der schwach dotierte Teil des Kollektors über den Subkollektorgebieten 5 entfernt ist (Fig. 2). Nach Entfernung der dritten Lackmaske wird mit bekannten Mitteln an den senkrechten Ätzkanten 13 ein Si₃N₄-Spacer restlos abgeätzt, und an den Steilkanten des Emitters und des Kollektomschlußgebietes wird ein SiO₂-Spacer 14 erzeugt. Anschließend wird mit bekannten Verfahren die Oberfläche der von Oxidresten befreiten Gebiete 5, 11, 12 und 9 in eine TiSi₂-Schicht 15 umgewandelt, wobei an den Oxidspacern 14 bei diesem selbstpositionierenden Prozeß (Salizidprozeß) kein Silizid entsteht, so daß die Isolation zwischen diesen Gebieten gewährleistet bleibt (Fig. 3). Im weiteren Prozeßablauf wird auf konventionelle Weise über der beschriebenen Transistorkonstruktion eine dicke SiO₂-Schicht 16 abgeschieden, planarisiert, mit Kontaktfenstern versehen, und Basis, Emitter und Kollektor werden mit Aluminiumleitbahnen 17 angeschlossen (Fig. 4 und 5).

Die beschriebene Transistorkonstruktion läßt sich ohne Schwierigkeiten in einen CMOS-Prozeß integrieren, bei welchem zweckmäßigerweise die Salizierung der Source/Drain- und Gate-Gebiete zusammen mit der Salizierung des Emitters, des Kollektors und des Basisanschlußgebietes erfolgen kann.

In der vorliegenden Erfindung wurde anhand eines konkreten Ausführungsbeispiels ein vertikaler Bipolartransistor und ein Verfahren zu seiner Herstellung erläutert. Es sei aber vermerkt, daß die vorliegende Erfindung nicht auf die Einzelheiten der Beschreibung im Ausführungsbeispiel eingeschränkt ist, da im Rahmen der Patentansprüche Änderungen und Abwandlungen beansprucht werden.

Ein Ausführungsbeispiel eines Verfahrens zur Herstellung einer integrierten Schaltung mit nMOS- und pMOS-Transistoren sowie erfindungsgemäßen vertikalen Bipolartransistoren wird nachfolgend anhand einer Auflistung seiner Verfahrensschritte beschrieben:
a) Erzeugung von Feldisolationsgebieten auf p-Substrat mittels konventioneller LOCOS-Oxidation oder anderer bekannter Verfahren,
b) Implantation von P und B durch je eine Lackmaske zur Realisierung retrograd dotierter n- und p-Wannen für die späteren p- und nMOS-Transistoren/Bipolartransistoren und Ausheilung/Aktivierung der Implante,
c) Entfernung der Oxidationsmaske aus den aktiven Gebieten und Erzeugung des Gateisolators für die MOS-Transistoren,
d) Abscheidung eines Schichtstapels aus amorphem oder polykristallinem SiGe, wobei die Ge-Konzentration zwischen 25 % und 70 % liegt, und polykristallinem Si, Implantation von Bor zur Dotierung der MOS-Transistor-Gates und der Widerstände,
e) Si3N4- oder SiNO-Abscheidung und Strukturierung der Si₃N₄-/SiNO-Schicht zusammen mit den Poly-SiGe/Si-Gates mittels einer Lackmaske, dabei auch Abdeckung der Gebiete der späteren Bipolartransistoren mit demselben Gatestapel,
f) Abscheidung eines selektiv ätzbaren Schutzschichtstapels über den strukturierten Gates
g) Erzeugung einer Lackmaske und Entfernung des Schutzschichtstapels, des Gatestapels und des Gateoxids auf den Gebieten der späteren Bipolartransistoren durch geeignete RIE- oder Naßätzverfahren,
h) Abscheidung eines Schichtstapels aus Si/SiGeC (B-dotiert)/Si in den geöffneten aktiven Gebieten durch differentielle Epitaxie bei gleichzeitiger Abscheidung eines entsprechenden polykristallinen Schichtstapels auf den mit Feldoxid bzw. mit dem Schutzschichtstapel versehenen Gebieten,
i) Abscheidung einer ersten etwa 30 nm bis 50 nm dünnen SiO₂-Schicht und Öffnung kleiner Fenster in derselben zur Definition der aktiven Emittergebiete mittels einer entsprechenden Lackmaske und geeigneter Ätzverfahren, Implantation von P und As zur optimalen Einstellung der Dotierungsprofile im Kollektor und im einkristallinen Teil des Emitters,
k) Abscheidung von vorzugsweise in Situ As-dotiertem, amorphem oder polykristallinem Silizium,
l) Abscheidung einer erstem Si₃N₄- oder SiNO-Schicht, welche vorzugsweise eine Dicke von 100 nm bis 200 nm aufweist,
m) Strukturierung der Si₃N₄- oder SiNO/Poly-Silizium-Doppelschicht mittels einer Lackmaske und RIE-Verfahren derart, daß der Überhang des Polysiliziums über das Emitterfenster 0,1 µm bis 0,4 µm beträgt,
n) Implantation von BF₂ zur Dotierung der Basisanschlußgebiete, Entfernung der ersten dünnen SiO₂-Schicht,
   - Abscheidung einer zweiten dünnen SiO₂-Schicht und einer zweiten Si3N4-Schicht,
   - Strukturierung der zweiten Si₃N₄-Schicht und der darunterliegenden Schichtfolge Si/SiGe/Si einschließlich der schwächer dotierten oberen Teilschicht des Kollektors mittels eines anisotropen RIE-Verfahrens derart, daß um die bereits strukturierten Polyemittergebiete jeweils ein schmales ringförmiges BF₂-implantiertes einkristallines Basisanschlußgebiet stehen bleibt, welches sich an einer Seite der Transistoren im Bereich des späteren Metallkontaktes als polykristalline Schicht auf dem Feldoxid fortsetzt und daß in einer das einkristalline Basisanschlußgebiet vorzugsweise U-förmig umschließenden Zone der betreffenden aktiven Gebiete die hochdotierte Subkollektorschicht freigelegt wird,
o) Erzeugung eines Si₃N₄-Spacers an den beim letzten RIE-Prozeß entstandenen Steilkanten und selbstjustierende Implantation von As-Ionen in die vorzugsweise U-förmige Kollektoranschlußzone,
p) Erzeugung einer vorzugsweise etwa 10 nm dünnen thermischen Oxidschicht über den As-implanlierlen Gebieten,
q) Entfernung der zweiten Si₃N₄-Schicht und des unter f) erzeugten selektiv ätzbaren Schutzschichtstapels durch einen selektiven Ätzprozeß,
r) Implantation von As- und BF₂-lonen zur Herstellung der Low Doped Drain-Gebiete (LDD-Gebiete) der MOS-Transistoren mittels einer oder zweier getrennter Lackmasken,
s) Erzeugung eines SiO₂-Spacers an den Kanten der Poly-Gates, den Emitterkanten und den Seitenkanten des Kollektoranschlußgebietes, wobei das Spaceroxid im Bereich der späteren Poly-Widerstände durch eine Lackmaske vor dem RIE-Prozeß geschützt wird,
t) vorzugsweise 10 nm dicke thermische Reoxidation der freigelegten Si-Gebiete und Implantation der n+ und p+ S/D-Gebiete,
u) Rapid Thermal Annealing (RTA) bei etwa 1000 °C,
v) selektive Ätzung der Si₃N₄/SiNO-Schichten über den Polygates und über den Polyemittergebieten,
w) Abscheidung einer vorzugsweise etwa 20 bis 30 nm dünnen Ti-Schicht,
x) Bildung von TiSi₂ auf Source, Drain und Gates der MOS-Transistoren und Emitter, Basis und Kollektor der Bipolartransistoren und Entfernung der Ti/TiN-Restschichten durch selektives Ätzen (Salizid-Prozeß) und
y) Isolatorabscheidung, Planarisierung, Kontaktfensteröffnung und Mehrebenenmetallisierung entsprechend bekannten Standardprozessen zur Komplettierung der BiCMOS-Schaltungen.

## Patentansprüche

1. Vertikaler Bipolartransistor mit einem Emitter (9), einer Basis (6), einem Basisanschlußgebiet (11, 12), einem Kollektor (4) und einem im Subkollektor (5) angeordneten und zum Basisanschlußgebiet selbstpositionierten Kollektoranschluß bei dem
- mindestens ein innerer Teilbereich (11) des Basisanschlußgebietes in Form einer schmalen, den Emitter ringförmig umschließenden Schichtkombination aus einer hochdotierten einkristallinen Halbleiterzone und einem darüberliegenden hochleitfähigen Metallsilizid (15) ausgebildet ist, wobei das Metallsilizid die gesamte Oberfläche der hochdotierten einkristallinen Halbleiterzone bedeckt und kontaktiert, mit Ausnahme an den Emitter angrenzender, sehr schmaler Randgebiete, die unter zur Berandung der hochdotierten einkristallinen Halbleiterzone selbstpositionierten ersten Abdeckzonen (14) aus einem isolierenden Material, sogenannten Spacern, liegen, wobei
- der durch eine Öffnung des Kollektors erstellte Kollektoranschluss im Subkollektor gegenüber dem einkristallinen inneren Teilbereich des Basisanschlußgebietes tieferliegend angeordnet ist und auf seiner gesamten Oberfläche mit einem hochleitfähigen Metallsilizid (15) bedeckt und kontaktiert ist, mit Ausnahme schmaler Randgebiete, die, zur Berandung des Kollektors (4), unter einem Paar zweiter selbstpositionierter Abdeckzonen (14) aus einem isolierenden Material liegen,
**dadurch gekennzeichnet, daß**
der Kollektoranschluss und das Metallsilizid, das den Kollektoranschluß bedeckt, den einkristallinen inneren Teilbereich des Basisanschlußgebietes lateral an drei Seiten, vorzugsweise U-förmig, umgeben.

2. Vertikaler Bipolartransistor nach Anspruch 1, bei dem der einkristalline innere Teilbereich des Basisanschlußgebietes (11, 12) an drei annähernd gleich langen Seiten an den Bereich des Kollektoranschlusses grenzt.

3. Vertikaler Bipolartransistor nach Anspruch 1 oder 2, bei dem eine innere Basis (6) und der einkristalline Teil des Basisanschlußgebietes (11, 12) unterhalb des hochleitfähigen Metallsilizids (15) aus epitaxial abgeschiedenem Si oder SiGe besteht.

4. Vertikaler Bipolartransistor nach Anspruch 3, bei dem ein äußerer Teilbereich des Basisanschlußgebietes (7, 12), bestehend aus einem Metallsilizid (15) auf einer hochdotierten polykristallinen Schicht des gleichen Materials und vom gleichen Dotierungstyp wie die unterhalb des hochleitfähigen Metallsilizids liegende epitaxial abgeschiedene einkristalline Teilschicht des inneren Teilbereichs (11) des Basisanschlußgebietes (11,12), durch eine dicke Isolatorschicht (2) vom Kollektor (4) bzw. vom einkristallinen Halbleitersubstrat (1) getrennt ist und zum Kollektor (4) bzw. zum Substrat eine im Vergleich mit dem inneren Teilbereich (11) des Basisanschlußgebietes (11, 12) sehr geringe Kapazität besitzt.

5. Verfahren zur Herstellung eines Vertinalen Bipolartransistor, der einen Emitter (9), eine Basis (6), ein Basisanschlußgebiet (11, 12), einen Kollektor (4) und einen im Subkollektor (5) angeordneten und zum Basisanschlußgebiet selbstpositionierten Kollektoranschluß aufweist, bei dem
- mindestens ein innerer Teilbereich (11) des Basisanschlußgebietes in Form einer schmalen, den Emitter ringförmig umschließenden Schichtkombination aus einer hochdotierten einkristallinen Halbleiterzone und einem darüberliegenden hochleitfähigen Metallsilizid (15) ausgebildet wird, wobei das Metallsilizid die gesamte Oberfläche der hochdotierten einkristallinen Halbleiterzone bedeckt und kontaktiert, mit Ausnahme an den Emitter angrenzender, sehr schmaler Randgebiete, die unter zur Berandung der hochdotierten einkristallinen Halbleiterzone selbstpositionierten ersten Abdeckzonen (14) aus einem isolierenden Material, sogenannten Spacern, liegen, wobei
- der durch eine Öffnung des Kollektors erstellte Kollektoranschluss im Subkollektor gegenüber dem einkristallinen inneren Teilbereich des Basisanschlußgebietes tieferliegend angeordnet wird und auf seiner gesamten Oberfläche mit einem hochleitfähigen Metallsilizid (15) bedeckt und kontaktiert wird, mit Ausnahme schmaler Randgebiete, die, zur Berandung des Kollektors (4), unter einem Paar zweiter selbstpositionierter Abdeckzonen (14) aus einem isolierenden Material angeordnet werden,
**dadurch gekennzeichnet, daß** der Kollektoranschluss und das Metallsilizid, das den Kollektoranschluß bedeckt, den einkristallinen inneren Teilbereich des Basisanschlußgebietes lateral an drei Seiten, vorzugsweise U-förmig, umgebend hergestellt werden.

6. Verfahren nach Anspruch 5 zur herstellung eines Bipolartransistors der die Merkmale des Anspruchs 4 aufweist, bei dem mindestens ein Teil der hochdotierten polykristallinen Schicht des äußeren Teilbereichs des Basisanschlußgebietes (12) während eines Epitaxieprozesses, der zur Herstellung der inneren Basis (6) und des inneren Teilbereichs (11) des Basisanschlußgebietes (11, 12) dient, simultan abgeschieden wird.

7. Verfahren nach Anspruch 5 oder 6, bei dem der Kollektor (4) gleichzeitig mit Wannen eines Typs auf demselben Substrat erzeugter MOS-Transistoren erzeugt wird und im wesentlichen das gleiche Vertikalprofil wie die Wannen aufweist.

8. Verfahren nach einem der Ansprüche 5 bis 7, bei dem das Basisanschlußgebiet (11,12) zusammen mit dem Kollektoranschluß und/oder dem Emitter saliziert wird.

9. Verfahren nach einem oder der Ansprüche 5 bis 8, bei dem vor der Silizidbildung im gesamten Bereich des Kollektoranschlusses eine schwach dotierte Kollektorzone (4) durch ein geeignetes Ätzverfahren entfernt wird.

## Claims

1. Vertical bipolar transistor having an emitter (9), a base (6), a base connection region (11, 12), a collector (4) and a collector connection arranged in the sub-collector (5) and self-positioned to the base connection region, wherein
- at least one inner partial region (11) of the base connection region is constructed in the form of a narrow layer combination encircling the emitter consisting of a highly doped monocrystalline semiconductor zone and above it a highly conductive metal silicide (15), wherein the metal silicide covers and contacts the entire surface of the highly doped monocrystalline semiconductor zone, with the exception of very narrow edge regions adjacent to the emitter which are located underneath first covering zones (14) of an insulating material, so-called spacers, self-positioned to the edge of the highly doped monocrystalline semiconductor zone, wherein
- the collector connection provided through an opening in the collector is arranged in the subcollector, lower down than the monocrystalline inner partial region of the base connection region, and is covered and contacted over its entire surface with a highly conductive metal silicide (15), with the exception of narrow edge regions which are located towards the edge of the collector (4) under a pair of second self-positioned covering zones (14) of an insulating material,
**characterised in that**
the collector connection and the metal silicide that covers the collector connection surround the monocrystalline inner partial region of the base connection region laterally on three sides, preferably in a U-shape.

2. Vertical bipolar transistor according to claim 1, wherein the monocrystalline inner partial region of the base connecting region (11, 12) adjoins the region of the collector connection on three sides of approximately equal length.

3. Vertical bipolar transistor according to claim 1 or 2, wherein an inner base (6) and the monocrystalline part of the base connection region (11, 12) underneath the highly conductive metal silicide (15) consists of epitaxially precipitated Si or SiGe.

4. Vertical bipolar transistor according to claim 3, wherein an outer partial region of the base connection region (7, 12), consisting of a metal silicide (15) on a highly doped polycrystalline layer of the same material and of the same doping type as the epitaxially precipitated monocrystalline partial layer of the inner partial region (11) of the base connection region (11, 12) located underneath the highly conductive metal silicide is separated from the collector (4) or from the monocrystalline semiconductor substrate (1) by a thick insulating layer and has very low capacitance to the collector (4) or to the substrate compared with the inner partial region (11) of the base connecting region (11, 12).

5. Method for producing a vertical bipolar transistor which comprises an emitter (9), a base (6), a base connecting region (11, 12), a collector (4) and a collector connection arranged in the sub-collector (5) and self-positioned to the base connection region, wherein
- at least one inner partial region (11) of the base connection region is constructed in the form of a narrow layer combination encircling the emitter consisting of a highly doped monocrystalline semiconductor zone and above it a highly conductive metal silicide (15), wherein the metal silicide covers and contacts the entire surface of the highly doped monocrystalline semiconductor zone, with the exception of very narrow edge regions adjacent to the emitter which are located underneath first covering zones (14) of an insulating material, so-called spacers, self-positioned to the edge of the highly doped monocrystalline semiconductor zone, wherein
- the collector connection provided through an opening in the collector is arranged in the subcollector, lower down than the monocrystalline inner partial region of the base connection region, and is covered and contacted over its entire surface with a highly conductive metal silicide (15), with the exception of narrow edge regions which are located towards the edge of the collector (4) under a pair of second self-positioned covering zones (14) of an insulating material,
**characterised in that** the collector connection and the metal silicide that covers the collector connection are produced to surround the monocrystalline inner partial region of the base connection region laterally on three sides, preferably in a U-shape.

6. Method according to claim 5 for producing a bipolar transistor which comprises the features of claim 4, wherein at least part of the highly doped polycrystalline layer of the outer partial region of the base connection region (12) is precipitated simultaneously during an epitaxy process which serves to produce the inner base (6) and the inner partial region (11) of the base connection region (11, 12).

7. Method according to claim 5 or 6, wherein the collector (4) is produced simultaneously with wells of a type of MOS transistor produced on the same substrate and has substantially the same vertical profile as the containers.

8. Method according to one of claims 5 to 7, wherein the base connecting region (11,12) is siliconised together with the collector connection and/or the emitter.

9. Method according to one of claims 5 to 8, wherein before the silicide formation throughout the region of the collector connection a weakly doped collector zone (4) is removed by a suitable etching process.

## Revendications

1. Transistor bipolaire vertical, avec un émetteur (9), une base (6), un domaine de raccordement de base (11, 12), un collecteur (4) et un raccordement de collecteur, agencé dans un sous-collecteur (5) et auto-positionné par rapport au domaine de raccordement de base, dans lequel,
- au moins une zone partielle intérieure (11) du domaine de raccordement de base est réalisée sous forme d'une étroite combinaison de couches, entourant en forme d'anneau l'émetteur, constituée d'une zone à semi-conducteur monocristalline fortement dopée et d'un siliciure métallique (15) hautement conducteur, disposé au-dessus, le siliciure métallique couvrant la totalité de la surface de la zone à semi-conducteur monocristalline fortement dopée et entrant en contact avec elle, à l'exception de zones de bordure très étroites, limitrophes à l'émetteur, situées au-dessous de premières zones de recouvrement (14) auto-positionnées, pour border la zone à semi-conducteur monocristalline fortement dopée, composées d'un matériau isolant, ce que l'on appelle des espaceurs, où
- le raccordement de collecteur, établi à travers une ouverture du collecteur, est disposé dans le sous-collecteur, plus profondément que la zone partielle intérieure monocristalline du domaine de raccordement de base et couvert, sur la totalité de sa surface, avec du siliciure métallique (15) hautement conducteur et mis en contact, à l'exception de zones de bordure étroites, qui, pour border le collecteur (4), sont situées au-dessous d'une paire de deuxièmes zones de recouvrement (14) auto-positionnées, composées d'un matériau isolant,
**caractérisé en ce que**
le raccordement de collecteur et le siliciure métallique, qui couvre le raccordement de collecteur, entoure latéralement la zone partielle intérieure monocristalline du domaine de raccordement de base en trois côtés, de préférence entourent en forme de U.

2. Transistor bipolaire vertical selon la revendication 1, dans lequel la zone partielle intérieure monocristalline du domaine de raccordement de base (11, 12) est limitrophe à la zone du raccordement de collecteur en trois côtés de longueur à peu près égale.

3. Transistor bipolaire vertical selon la revendication 1 ou 2, dans lequel une base intérieure (6) et la partie monocristalline du domaine de raccordement de base (11, 12) située au-dessous du siliciure métallique (15) hautement conducteur sont composés de Si ou de SiGe déposé de manière épitaxale.

4. Transistor bipolaire vertical selon la revendication 3, dans lequel une zone partielle extérieure du domaine de raccordement de base (7, 12), composée d'un siliciure métallique (15) sur une couche polycristalline fortement dopée du même matériau et d'un type de dopage identique à la couche partielle monocristalline, déposée de manière épitaxiale, située au-dessous du siliciure métallique hautement conducteur, de la zone partielle intérieure (11) du domaine de raccordement de base (11, 12), est séparée du collecteur (4) ou du substrat semi-conducteur (1) monocristallin par une épaisse couche d'isolation (2) et présente, par rapport au collecteur (4) ou au substrat, une capacité très faible par rapport à la zone partielle intérieure (11) du domaine de raccordement de base (11, 12).

5. Procédé de fabrication d'un transistor bipolaire vertical, avec un émetteur (9), une base (6), un domaine de raccordement de base (11, 12), un collecteur (4) et un raccordement de collecteur, agencé dans un sous-collecteur (5) et auto-positionné par rapport au domaine de raccordement de base, dans lequel,
- au moins une zone partielle intérieure (11) du domaine de raccordement de base est réalisée sous forme d'une étroite combinaison de couches, entourant en forme d'anneau l'émetteur, constituée d'une zone à semi-conducteur monocristalline fortement dopée et d'un siliciure métallique (15) hautement conducteur, disposé au-dessus, le siliciure métallique couvrant la totalité de la surface de la zone à semi-conducteur monocristalline fortement dopée et entrant en contact avec elle, à l'exception de zones de bordure très étroites, limitrophes à l'émetteur, situées au-dessous de premières zones de recouvrement (14) auto-positionnées, pour border la zone à semi-conducteur monocristalline fortement dopée, composées d'un matériau isolant, ce que l'on appelle des espaceurs, où
- le raccordement de collecteur, établi à travers une ouverture du collecteur, est disposé dans le sous-collecteur, plus profondément que la zone partielle intérieure monocristalline du domaine de raccordement de base et couvert, sur la totalité de sa surface, avec du siliciure métallique (15) hautement conducteur et mis en contact, à l'exception de zones de bordure étroites, qui, pour border le collecteur (4), sont situées au-dessous d'une paire de deuxièmes zones de recouvrement (14) auto-positionnées, composées d'un matériau isolant,
**caractérisé en ce que**
le raccordement de collecteur et le siliciure métallique, qui couvre le raccordement de collecteur, sont fabriqués en entourant latéralement la zone partielle intérieure monocristalline du domaine de raccordement de base en trois côtés, de préférence en entourant en forme de U.

6. Procédé selon la revendication 5, dans lequel, pour fabriquer un transistor bipolaire présentant les caractéristiques de la revendication 4, au moins une partie de la couche polycristalline fortement dopée de la zone partielle extérieure du domaine de raccordement de base (12) est déposée simultanément pendant le processus d'épitaxie servant à la fabrication de la base intérieure (6) et de la zone partielle intérieure (11) du domaine de raccordement de base (11, 12).

7. Procédé selon la revendication 5 ou 6, dans lequel le collecteur (4) est produit simultanément à des cuves d'un type de transistors MOS fabriqués sur le même substrat et présente sensiblement le même profil vertical que les cuves.

8. Procédé selon l'une des revendications 5 à 7, dans lequel le domaine de raccordement de base (11, 12) est silicié conjointement avec le raccordement de collecteur et/ou l'émetteur.

9. Procédé selon l'une des revendications 5 à 8, dans lequel, avant la formation de siliciure, dans la totalité de la zone du raccordement de collecteur, une zone de collecteur (4) faiblement dopée est enlevée au moyen d'un processus de gravure approprié.
